# EUROPEAN PATENT APPLICATION

(11) **EP 4 156 155 A1**
(43) Date of publication of application: **29.03.2023**
(21) Application number: 21807857.4
(22) Date of filing: 28.04.2021
(51) Int. Cl.: G09F 9/33

(54) **LIGHT-EMITTING MODULE, DISPLAY MODULE, DISPLAY SCREEN, AND DISPLAY**

(30) Priority: 22.05.2020 CN 202010439797
(71) Applicant: Beijing Ivisual 3D Technology Co., Ltd., Beijing 100055 (CN); Visiotech Ventures Pte. Ltd., Singapore 188979 (SG)
(72) Inventor: DIAO, Honghao, Beijing 100055 (CN)
(74) Representative: Zacco GmbH
(86) International application number: PCT/CN2021/090588
(87) International publication number: WO 2021/233099

(57) **Abstract**

The present application relates to the technical field of optics, and discloses a light-emitting module (100), including: a light-emitting unit layer (110), including a plurality of light-emitting units (111), where a light-emitting unit light isolation structure (300) is arranged between two adjacent light-emitting units (111) in part or all of the plurality of light-emitting units (111). According to the light-emitting module (100), light emitted by the light-emitting units (111) is prevented from being transmitted in an undesired direction as far as possible by arranging the light-emitting unit light isolation structure (300) between two adjacent light-emitting units (111) in part or all of the plurality of light-emitting units (111), thereby benefiting improvement of display effect. The present application further discloses a display module, a display screen and a display.

## Description

The present application claims priority to the Chinese Patent Application with an application number of 202010439797.0 and a title of *"Light-emitting Module, Display Module, Display Screen and Display",* filed to China National Intellectual Property Administration on May, 22nd, 2020, the disclosures of which are hereby incorporated by reference.

### TECHNICAL FIELD

The present application relates to the technical field of optics, and for example, relates to a light-emitting module, a display module, a display screen and a display.

### BACKGROUND

At present, light-emitting units are usually used to support display.

In a process of implementing embodiments of the present disclosure, at least the following problems are found in related technologies:
Part of light emitted by the light-emitting units will be transmitted in an undesired direction; and the light transmitted in the undesired direction will influence a display effect.

### SUMMARY

In order to provide a basic understanding of some aspects of the disclosed embodiments, a brief summary is given below. The summary is not intended to be a general comment, nor to identify key/important components or describe the scope of protection of the embodiments, but to be a preface to the following detailed description.

Embodiments of the present disclosure provide a light-emitting module, a display module, a display screen and a display, to solve a technical problem that part of light emitted by light-emitting units will be transmitted in an undesired direction, thereby influencing a display effect.

The light-emitting module provided by embodiments of the present disclosure includes:
a light-emitting unit layer, including a plurality of light-emitting units;
where a light-emitting unit light isolation structure is arranged between two adjacent light-emitting units in part or all of the plurality of light-emitting units.

In some embodiments, the light-emitting unit light isolation structure may be arranged in a partial or whole region between the two adjacent light-emitting units.

In some embodiments, there may be a light-emitting unit spacing region between two adjacent light-emitting units; and the light-emitting unit light isolation structure may be arranged in a part or whole of the light-emitting unit spacing region.

In some embodiments, the two adjacent light-emitting units may include a first light-emitting unit and a second light-emitting unit, where the first light-emitting unit may include a first surface close to the second light-emitting unit; and the second light-emitting unit may include a second surface close to the first light-emitting unit. Optionally, the light-emitting unit light isolation structure may be arranged on at least one of the first surface and the second surface, or not be in contact with the first surface or the second surface.

In some embodiments, the light-emitting unit light isolation structure may be arranged in a light-transmissive region of at least one of the first surface and the second surface.

In some embodiments, the light-emitting unit light isolation structure may include a light-emitting unit light isolation body.

In some embodiments, the light-emitting unit light isolation body may be nonconductive and include a light isolation material.

In some embodiments, the light-emitting unit light isolation body may be conductive. Optionally, the light-emitting unit light isolation structure may further include an insulation structure arranged between the light-emitting unit light isolation body and a light-emitting unit in need of being insulated from the light-emitting unit light isolation body.

In some embodiments, the insulation structure may be arranged between the light-emitting unit light isolation body and at least one of the two adjacent light-emitting units.

In some embodiments, the insulation structure may cover a part or whole of the light-emitting unit light isolation body.

In some embodiments, at least one of the light-emitting unit light isolation body and the insulation structure may include the light isolation material.

In some embodiments, the insulation structure may be in contact with at least one of the two adjacent light-emitting units. Optionally, the insulation structure may not be in contact with the two adjacent light-emitting units.

In some embodiments, the light isolation material may include at least one of a light absorption material and a light reflection material.

In some embodiments, part or all shapes in cross-sectional shapes of the light-emitting unit light isolation structure along a light-exiting direction of the light-emitting unit layer may include at least one of rectangular quadrangle, triangle and trapezoid.

In some embodiments, the cross-sectional shapes of the light-emitting unit light isolation structure along the light-exiting direction of the light-emitting unit layer may include a trapezoid; and an upper base of the trapezoid may face a light-exiting side of the light-emitting unit layer.

In some embodiments, the light-emitting module may further include a light conversion layer arranged at the light-emitting unit layer.

In some embodiments, the light conversion layer may be arranged at a light-exiting surface of the light-emitting unit layer.

In some embodiments, part or all of the plurality of light-emitting units may be unpackaged structures.

In some embodiments, the plurality of light-emitting units may include:
at least one of a Light-Emitting Diode (LED), a Mini LED and a Micro LED.

The display module provided by embodiments of the present disclosure includes the light-emitting module.

The display screen provided by embodiments of the present disclosure includes the display module.

The display provided by embodiments of the present disclosure includes the display screen.

The light-emitting module, the display module, the display screen and the display provided by embodiments of the present disclosure may achieve the following technical effects:
Light emitted by the light-emitting units is prevented from being transmitted in an undesired direction as far as possible by arranging the light-emitting unit light isolation structure between two adjacent light-emitting units in part or all of the plurality of light-emitting units, thereby benefiting improvement of display effect.

The above general description and the following description are exemplary and explanatory only, and are not intended to limit the present application.

### DESCRIPTION OF DRAWINGS

One or more embodiments are illustrated by the corresponding drawings, and the illustrations and drawings do not limit the embodiments. Elements having the same reference numerals in the drawings are shown as similar elements, and the drawings are not intended to limit the scale, where:
Fig. 1 is a structural schematic diagram of a light-emitting module provided by embodiments of the present disclosure;
Figs. 2A, 2B and 2C are structural schematic diagrams of a light-emitting unit light isolation structure provided by embodiments of the present disclosure;
Figs. 3A, 3B, 3C, 3D and 3E are other structural schematic diagrams of the light-emitting unit light isolation structure provided by embodiments of the present disclosure;
Figs. 4A, 4B, 4C and 4D are other structural schematic diagrams of the light-emitting unit light isolation structure provided by embodiments of the present disclosure;
Figs. 5A, 5B, 5C, 5D, 5E, 5F, 5G, 5H, 51, 5J, 5K, 5L, 5M and 5N are other structural schematic diagrams of the light-emitting unit light isolation structure provided by embodiments of the present disclosure;
Fig. 6 is a structural schematic diagram of a light-emitting unit light isolation body provided by embodiments of the present disclosure;
Fig. 7 is another structural schematic diagram of the light-emitting unit light isolation body provided by embodiments of the present disclosure;
Fig. 8 is another structural schematic diagram of the light-emitting unit light isolation structure provided by embodiments of the present disclosure;
Figs. 9A, 9B and 9C are other structural schematic diagrams of the light-emitting unit light isolation structure provided by embodiments of the present disclosure;
Figs. 10A, 10B, 10C, 10D and 10E are other structural schematic diagrams of the light-emitting unit light isolation structure provided by embodiments of the present disclosure;
Figs. 11A, 11B, 11C, 11D and 11E are other structural schematic diagrams of the light-emitting unit light isolation structure provided by embodiments of the present disclosure;
Figs. 12A, 12B, 12C and 12D are other structural schematic diagrams of a light isolation material provided by embodiments of the present disclosure;
Figs. 13A, 13B, 13C, 13D, 13E, 13F, 13G and 13H are other structural schematic diagrams of the light-emitting module provided by embodiments of the present disclosure;
Fig. 14 is another schematic diagram of the light-emitting module provided by embodiments of the present disclosure;
Fig. 15 is another schematic diagram of the light-emitting module provided by embodiments of the present disclosure;
Fig. 16 is a structural schematic diagram of a display module provided by embodiments of the present disclosure;
Fig. 17 is a structural schematic diagram of a display screen provided by embodiments of the present disclosure; and
Fig. 18 is a structural schematic diagram of a display provided by embodiments of the present disclosure.

### Reference numerals:

100: light-emitting module; 110: light-emitting unit layer; 111: light-emitting unit; 300: light-emitting unit light isolation structure; 301: light-emitting unit light isolation body; 302: light isolation material; 3021: light absorption material; 3022: light reflection material; 303: insulation structure; 310: light-emitting unit spacing region; 320: first light-emitting unit; 321: first surface; 330: second light-emitting unit; 331: second surface; 333: light-transmissive region; 334: light-transmissive region; A: upper base; P: plane direction; S: light-exiting surface; X: light-exiting side; Z: light-exiting direction; 410: light conversion layer; 700: display module; 800: display screen; and 900: display.

### DETAILED DESCRIPTION

To understand features and technical contents of embodiments of the present disclosure in more detail, implementation of the embodiments of the present disclosure is described in detail below with reference to accompanying drawings; and the accompanying drawings are used for reference only, rather than limiting the embodiments of the present disclosure. In following technical description, for the convenience of explanation, a thorough understanding of the disclosed embodiments is provided through more details. However, one or more embodiments may be implemented without the details. In other cases, to simplify the accompanying drawings, well-known structures and apparatuses may be shown simplistically.

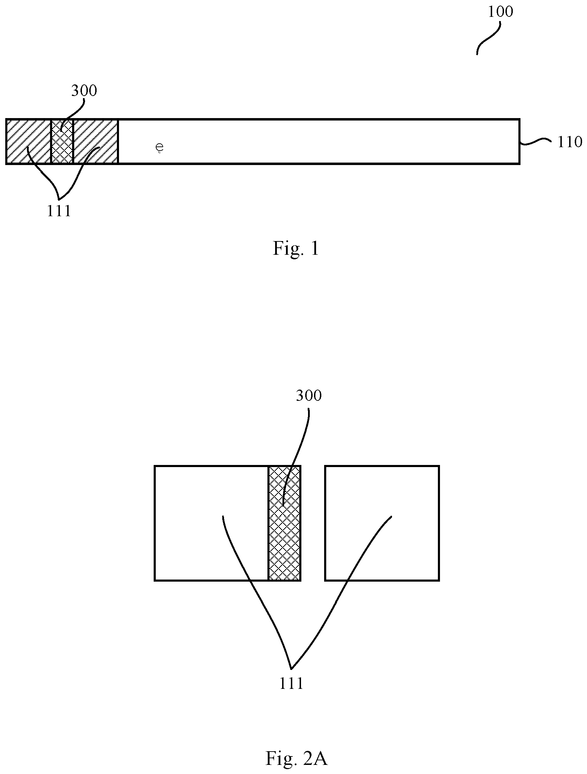

Referring to Fig. 1, embodiments of the present disclosure provide a light-emitting module 100, including:
a light-emitting unit layer 110, including a plurality of light-emitting units 111,
where a light-emitting unit light isolation structure 300 is arranged between two adjacent light-emitting units 111 in part or all of the plurality of light-emitting units 111.

In this way, the light-emitting unit light isolation structure 300 is capable of preventing light emitted by two adjacent light-emitting units 111 from being transmitted in an undesired direction as far as possible (e.g., the light emitted by the two adjacent light-emitting units 111 is transmitted to each other), thereby benefiting improvement of display effect.

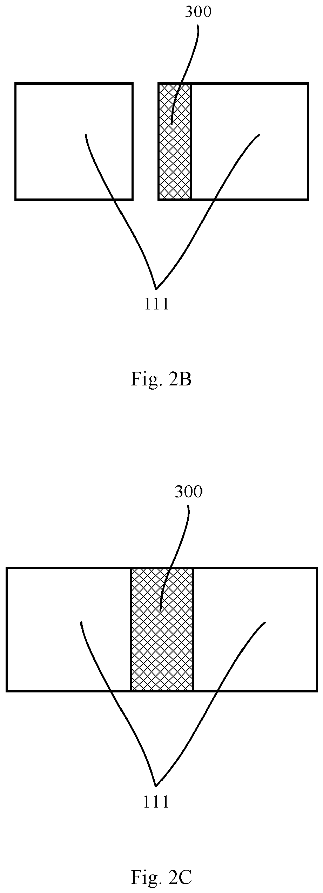

Referring to Figs. 2A, 2B and 2C, in some embodiments, the light-emitting unit light isolation structure 300 may be arranged in a partial or whole region between the two adjacent light-emitting units 111.

In some embodiments, as shown in Fig. 2A, the light-emitting unit light isolation structure 300 is arranged in a partial region between the two adjacent light-emitting units 111; and the partial region is located between the two adjacent light-emitting units 111 and close to one of the light-emitting units 111 (a light-emitting unit 111 located on the left in the figure).

In some embodiments, as shown in Fig. 2B, the light-emitting unit light isolation structure 300 is arranged in a partial region between the two adjacent light-emitting units 111; and the partial region is located between the two adjacent light-emitting units 111 and opposite to a position of the light-emitting unit light isolation structure 300 in Fig. 2A (close to a light-emitting unit 111 located on the right in the figure).

In some embodiments, as shown in Fig. 2C, the light-emitting unit light isolation structure 300 is arranged in a whole region between the two adjacent light-emitting units 111.

In some embodiments, the region, where the light-emitting unit light isolation structure 300 is arranged, between the two adjacent light-emitting units 111 may be determined according to actual conditions such as process requirements, as long as the light-emitting unit light isolation structure 300 is capable of preventing the light emitted by the two adjacent light-emitting units 111 from being transmitted in an undesired direction (e.g., the light emitted by the two adjacent light-emitting units 111 is transmitted to each other).

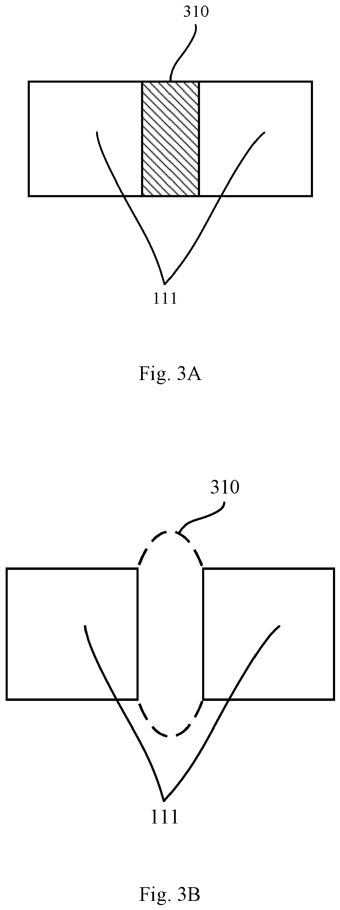

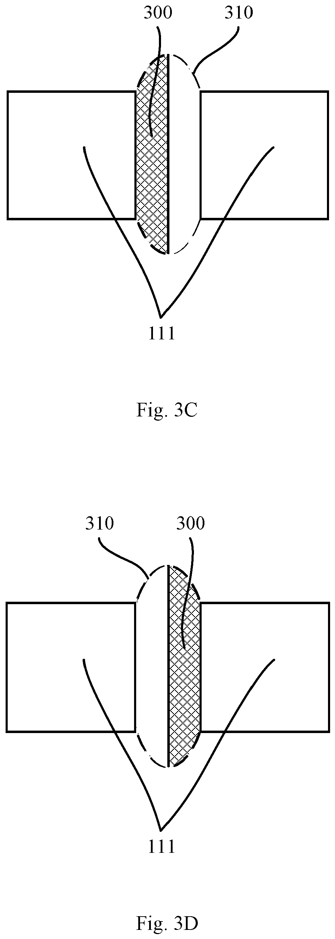

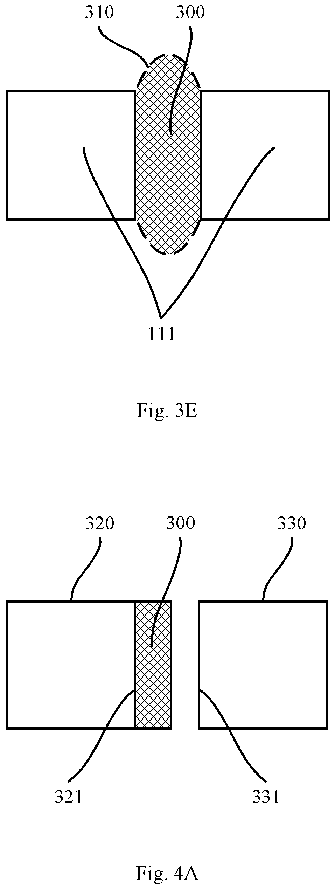

Referring to Figs. 3A, 3B, 3C, 3D and 3E, in some embodiments, there may be a light-emitting unit spacing region 310 between two adjacent light-emitting units 111; and the light-emitting unit light isolation structure 300 may be arranged in a part or whole of the light-emitting unit spacing region 310.

In some embodiments, as shown in Fig. 3A, a light-emitting unit spacing region 310 having a rectangular quadrangle shape may be used as the light-emitting unit spacing region between the two adjacent light-emitting units 111; the light-emitting unit spacing region 310 may smoothly connect the two adjacent light-emitting units 111, so that a projection jointly formed by the two adjacent light-emitting units 111 and the light-emitting unit spacing region 310 may form a regular shape such as a rectangular quadrangle as shown in Fig. 3A.

In some embodiments, the light-emitting unit spacing region 310 between the two adjacent light-emitting units 111 may not have the shape of the light-emitting unit spacing region 310 as shown in Fig. 3A, but may have other shapes such as circle, ellipse, triangle and trapezoid. Optionally, when the light-emitting unit spacing region 310 between the two adjacent light-emitting units 111 has other shapes such as circle, ellipse, triangle and trapezoid, the light-emitting unit spacing region 310 is possible to smoothly connect the two adjacent light-emitting units 111, so that the projection jointly formed by the two adjacent light-emitting units 111 and the light-emitting unit spacing region 310 may form a regular shape such as the rectangular quadrangle as shown in Fig. 3A.

In some embodiments, the position, shape, size and the like of the light-emitting unit spacing region 310 between the two adjacent light-emitting units 111 may be determined according to actual conditions such as process requirements. Optionally, regardless of the shape of the light-emitting unit spacing region 310 between the two adjacent light-emitting units 111, for convenience of description, a light-emitting unit spacing region 310 with an approximate ellipse shape shown by a dotted line in Fig. 3B may also be used as the light-emitting unit spacing region between the two adjacent light-emitting units 111.

In some embodiments, as shown in Fig. 3C, the light-emitting unit light isolation structure 300 is arranged in a partial region of the light-emitting unit spacing region 310 between the two adjacent light-emitting units 111; and the partial region is located between the two adjacent light-emitting units 111 and close to one of the light-emitting units 111 (a light-emitting unit 111 on the left in the figure).

In some embodiments, as shown in Fig. 3D, the light-emitting unit light isolation structure 300 is arranged in a partial region of the light-emitting unit spacing region 310 between the two adjacent light-emitting units 111; and the partial region is located between the two adjacent light-emitting units 111 and opposite to a position of the light-emitting unit light isolation structure 300 in Fig. 3C (close to a light-emitting unit 111 located on the right in the figure).

In some embodiments, as shown in Fig. 3E, the light-emitting unit light isolation structure 300 is arranged in a whole region of the light-emitting unit spacing region 310 between the two adjacent light-emitting units 111.

In some embodiments, a position, where the light-emitting unit light isolation structure 300 is arranged, in the light-emitting unit spacing region 310 between the two adjacent light-emitting units 111 may be determined according to actual conditions such as process requirements, as long as the light-emitting unit light isolation structure 300 is capable of preventing the light emitted by the two adjacent light-emitting units 111 from being transmitted in an undesired direction (e.g., the light emitted by the two adjacent light-emitting units 111 is transmitted to each other).

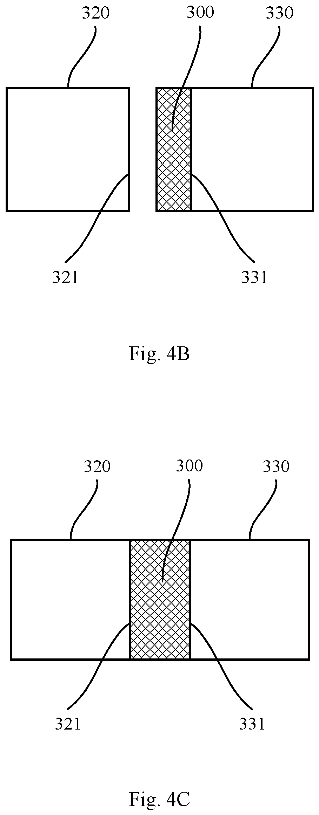

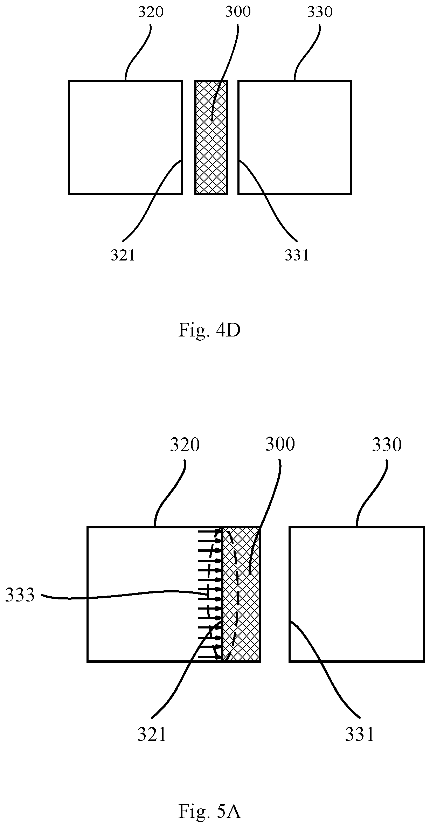

Referring to Figs. 4A, 4B, 4C and 4D, in some embodiments, the two adjacent light-emitting units 111 may include a first light-emitting unit 320 and a second light-emitting unit 330, where the first light-emitting unit 320 may include a first surface 321 close to the second light-emitting unit 330; and the second light-emitting unit 330 may include a second surface 331 close to the first light-emitting unit 320. Optionally, the light-emitting unit light isolation structure 300 may be arranged on at least one of the first surface 321 and the second surface 331, or not be in contact with the first surface 321 or the second surface 331.

In some embodiments, as shown in Fig. 4A, the light-emitting unit light isolation structure 300 is arranged at the first surface 321 of the first light-emitting unit 320, in contact with the first surface 321 of the first light-emitting unit 320, but not in contact with the second surface 331 of the second light-emitting unit 330.

In some embodiments, as shown in Fig. 4B, the light-emitting unit light isolation structure 300 is arranged at the second surface 331 of the second light-emitting unit 330, in contact with the second surface 331 of the second light-emitting unit 330, but not in contact with the first surface 321 of the first light-emitting unit 320.

In some embodiments, as shown in Fig. 4C, the light-emitting unit light isolation structure 300 is arranged at the first surface 321 of the first light-emitting unit 320 and the second surface 331 of the second light-emitting unit 330, in contact with the first surface 321 of the first light-emitting unit 320, and in contact with the second surface 331 of the second light-emitting unit 330.

In some embodiments, as shown in Fig. 4D, the light-emitting unit light isolation structure 300 is arranged between the first surface 321 of the first light-emitting unit 320 and the second surface 331 of the second light-emitting unit 330, not in contact with the first surface 321 of the first light-emitting unit 320, and not in contact with the second surface 331 of the second light-emitting unit 330.

In some embodiments, an arrangement relationship between the light-emitting unit light isolation structure 300 and each of the first light-emitting unit 320 and the second light-emitting unit 330 may be determined according to actual conditions such as process requirements, as long as the light-emitting unit light isolation structure 300 is capable of preventing the light emitted by the first light-emitting unit 320 and the second light-emitting unit 330 from being transmitted in an undesired direction (e.g., the light emitted by the first light-emitting unit 320 and the second light-emitting unit 330 is transmitted to each other).

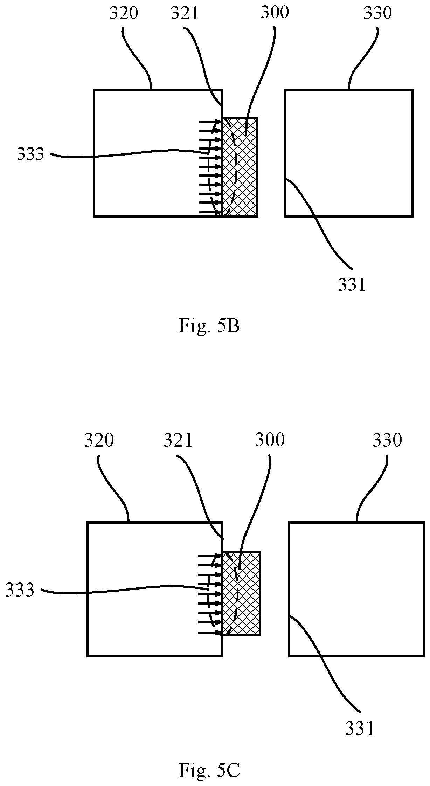

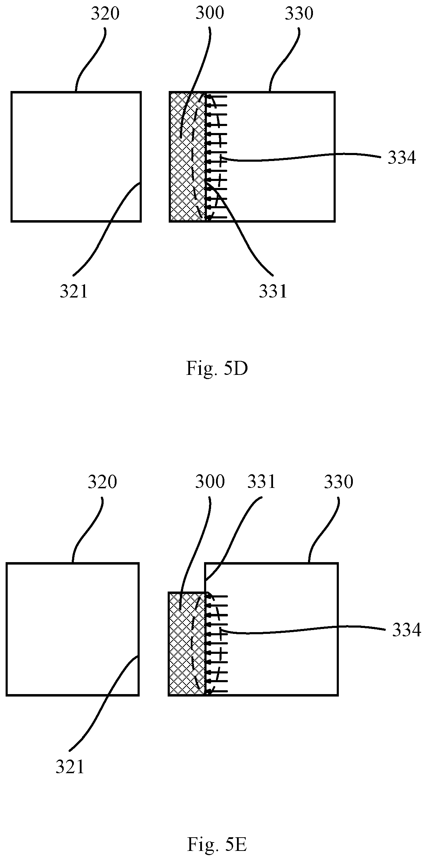

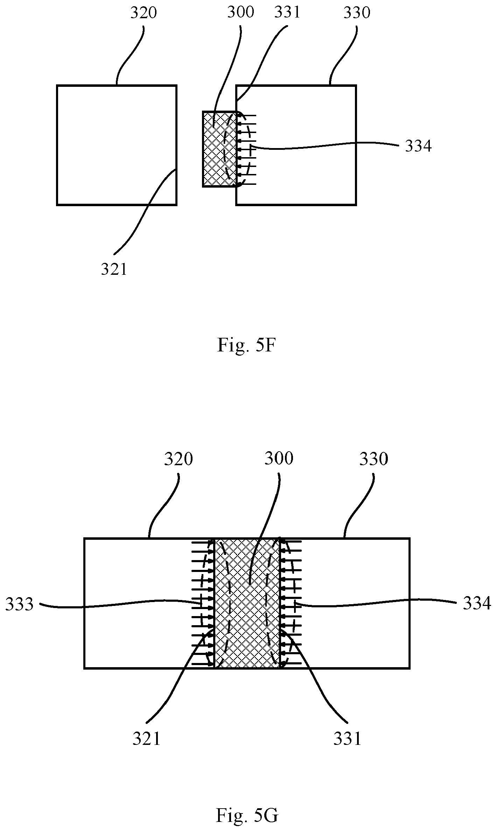

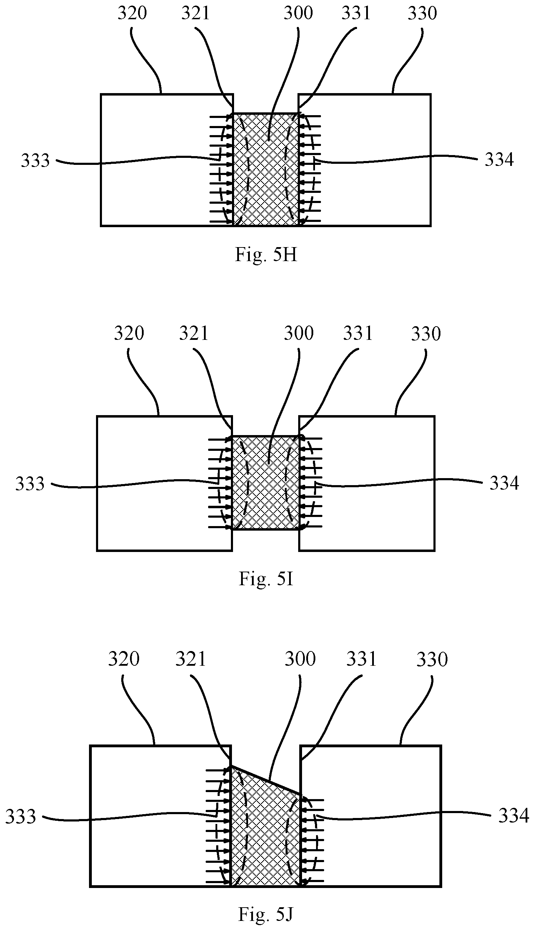

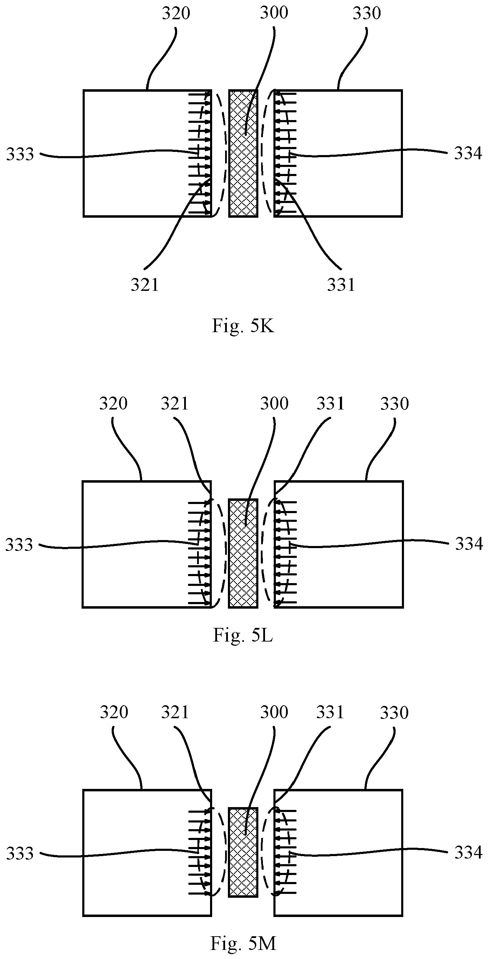

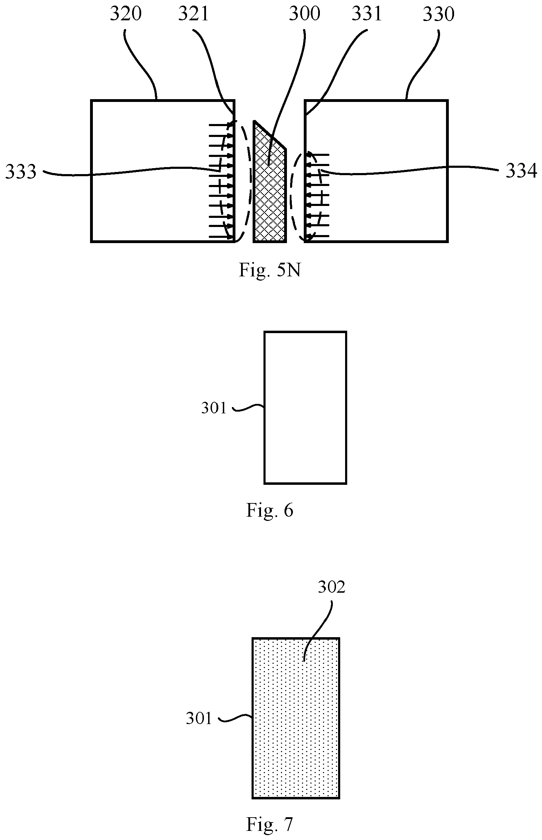

Referring to Figs. 5A, 5B, 5C, 5D, 5E, 5F, 5G, 5H, 51, 5J, 5K, 5L, 5M and 5N, in some embodiments, the light-emitting unit light isolation structure 300 may be arranged in a light-transmissive region of at least one of the first surface 321 and the second surface 331.

In some embodiments, as shown in Figs. 5A, 5B, 5C, 5D, 5E, 5F, 5G, 5H, 51, 5J, 5K, 5L, 5M and 5N, the arrow graphics exemplarily show a direction of part of light emitted by the light-emitting units 111. Optionally, for the convenience of identification, the light-transmissive regions 333 and 334 are surrounded by dotted lines.

In some embodiments, as shown in Fig. 5A, the light-transmissive region 333 of the first surface 321 of the first light-emitting unit 320 includes a whole region of the first surface 321. In this case, the light-emitting unit light isolation structure 300 may be arranged in the whole region of the first surface 321 and in contact with the whole region of the first surface 321, so that the light-emitting unit light isolation structure 300 may be arranged in the light-transmissive region 333 of the first surface 321.

In some embodiments, as shown in Figs. 5B and 5C, the light-transmissive region 333 of the first surface 321 of the first light-emitting unit 320 includes a partial region of the first surface 321. In this case, the light-emitting unit light isolation structure 300 may be arranged in a corresponding partial region of the first surface 321 and in contact with the corresponding partial region of the first surface 321, so that the light-emitting unit light isolation structure 300 may be arranged in the light-transmissive region 333 of the first surface 321.

In some embodiments, as shown in Fig. 5D, the light-transmissive region 334 of the second surface 331 of the second light-emitting unit 330 includes a whole region of the second surface 331. In this case, the light-emitting unit light isolation structure 300 may be arranged in the whole region of the second surface 331 and in contact with the whole region of the second surface 331, so that the light-emitting unit light isolation structure 300 may be arranged in the light-transmissive region 334 of the second surface 331.

In some embodiments, as shown in Figs. 5E and 5F, the light-transmissive region 334 of the second surface 331 of the second light-emitting unit 330 includes a partial region of the second surface 331. In this case, the light-emitting unit light isolation structure 300 may be arranged in a corresponding partial region of the second surface 331 and in contact with the corresponding partial region of the second surface 331, so that the light-emitting unit light isolation structure 300 may be arranged in the light-transmissive region 334 of the second surface 331.

In some embodiments, as shown in Fig. 5G, the light-transmissive region 333 of the first surface 321 of the first light-emitting unit 320 includes a whole region of the first surface 321; and the light-transmissive region 334 of the second surface 331 of the second light-emitting unit 330 includes the whole region of the second surface 331. In this case, the light-emitting unit light isolation structure 300 may be arranged in the whole region of the first surface 321 and the whole region of the second surface 331, and in contact with the whole region of the first surface 321 and the whole region of the second surface 331, so that the light-emitting unit light isolation structure 300 may be arranged in the light-transmissive region 333 of the first surface 321 and the light-transmissive region 334 of the second surface 331.

In some embodiments, as shown in Figs. 5H and 5I, the light-transmissive region 333 of the first surface 321 of the first light-emitting unit 320 includes a partial region of the first surface 321; the light-transmissive region 334 of the second surface 331 of the second light-emitting unit 330 includes a partial region of the second surface 331; and the light-transmissive region 333 of the first surface 321 is consistent with the light-transmissive region 334 of the second surface 331 (e.g., being identical in at least one of position, shape, area and the like). In this case, the light-emitting unit light isolation structure 300 may be arranged in the corresponding partial regions of the first surface 321 and the second surface 331, and contact with the corresponding partial regions of the first surface 321 and the second surface 331, so that the light-emitting unit light isolation structure 300 may be arranged at the first surface 321 and the light-transmissive region 334 of the second surface 331.

In some embodiments, as shown in Fig. 5J, the light-transmissive region 333 of the first surface 321 of the first light-emitting unit 320 includes a partial region of the first surface 321; the light-transmissive region 334 of the second surface 331 of the second light-emitting unit 330 includes a partial region of the second surface 331; and the light-transmissive region 333 of the first surface 321 is inconsistent with the light-transmissive region 334 of the second surface 331 (e.g., being different in at least one of position, shape, area and the like). In this case, the light-emitting unit light isolation structure 300 may be arranged in the corresponding partial regions of the first surface 321 and the second surface 331, and contact with the corresponding partial regions of the first surface 321 and the second surface 331, so that the light-emitting unit light isolation structure 300 may be arranged at the first surface 321 and the light-transmissive region 334 of the second surface 331.

In some embodiments, the light-transmissive region 333 of the first surface 321 of the first light-emitting unit 320 may include a whole region of the first surface 321; and the light-transmissive region 334 of the second surface 331 of the second light-emitting unit 330 may include a partial region of the second surface 331. In this case, the light-emitting unit light isolation structure 300 may be arranged in the whole region of the first surface 321 and the partial region of the second surface 331, and in contact with the whole region of the first surface 321 and the partial region of the second surface 331, so that the light-emitting unit light isolation structure 300 may be arranged at the first surface 321 and the light-transmissive region 334 of the second surface 331. Optionally, the light-transmissive region 333 of the first surface 321 of the first light-emitting unit 320 may include a partial region of the first surface 321; and the light-transmissive region 334 of the second surface 331 of the second light-emitting unit 330 may include a whole region of the second surface 331. In this case, the light-emitting unit light isolation structure 300 may be arranged in the partial region of the first surface 321 and the whole region of the second surface 331, and in contact with the partial region of the first surface 321 and the whole region of the second surface 331, so that the light-emitting unit light isolation structure 300 may be arranged at the first surface 321 and the light-transmissive region 334 of the second surface 331.

In some embodiments, as shown in Fig. 5K, the light-transmissive region 333 of the first surface 321 of the first light-emitting unit 320 includes the whole region of the first surface 321 and the whole region of the second surface 331. In this case, the light-emitting unit light isolation structure 300 may be arranged between the whole region of the first surface 321 and the whole region of the second surface 331, and not be in contact with the first surface 321 or the second surface 331, so that the light-emitting unit light isolation structure 300 may be arranged between the light-transmissive region 333 of the first surface 321 and the light-transmissive region 334 of the second surface 331.

In some embodiments, as shown in Figs. 5L and 5M, the light-transmissive region 333 of the first surface 321 of the first light-emitting unit 320 includes a partial region of the first surface 321; the light-transmissive region 334 of the second surface 331 of the second light-emitting unit 330 includes a partial region of the second surface 331; and the light-transmissive region 333 of the first surface 321 is consistent with the light-transmissive region 334 of the second surface 331 (e.g., being identical in at least one of position, shape, area and the like). In this case, the light-emitting unit light isolation structure 300 may be arranged between corresponding parts of regions of the first surface 321 and the second surface 331, and not be in contact with the first surface 321 or the second surface 331, so that the light-emitting unit light isolation structure 300 may be arranged between the light-transmissive region 333 of the first surface 321 and the light-transmissive region 334 of the second surface 331.

In some embodiments, as shown in Fig. 5N, the light-transmissive region 333 of the first surface 321 of the first light-emitting unit 320 includes a partial region of the first surface 321; the light-transmissive region 334 of the second surface 331 of the second light-emitting unit 330 includes a partial region of the second surface 331; and the light-transmissive region 333 of the first surface 321 is inconsistent with the light-transmissive region 334 of the second surface 331 (e.g., being different in at least one of position, shape, area and the like). In this case, the light-emitting unit light isolation structure 300 may be arranged between the corresponding partial region of the first surface 321 and the corresponding partial region of the second surface 331, and not be in contact with the first surface 321 or the second surface 331, so that the light-emitting unit light isolation structure 300 may be arranged between the first surface 321 and the light-transmissive region 334 of the second surface 331.

In some embodiments, the light-transmissive region 333 of the first surface 321 of the first light-emitting unit 320 may include a whole region of the first surface 321; and the light-transmissive region 334 of the second surface 331 of the second light-emitting unit 330 may include a partial region of the second surface 331. In this case, the light-emitting unit light isolation structure 300 may be arranged between the whole region of the first surface 321 and the partial region of the second surface 331, and not be in contact with the first surface 321 or the second surface 331, so that the light-emitting unit light isolation structure 300 may be arranged between the first surface 321 and the light-transmissive region 334 of the second surface 331. Optionally, the light-transmissive region 333 of the first surface 321 of the first light-emitting unit 320 may include a partial region of the first surface 321; and the light-transmissive region 334 of the second surface 331 of the second light-emitting unit 330 may include a whole region of the second surface 331. In this case, the light-emitting unit light isolation structure 300 may be arranged between the partial region of the first surface 321 and the whole region of the second surface 331, and not be in contact with the first surface 321 or the second surface 331, so that the light-emitting unit light isolation structure 300 may be arranged between the first surface 321 and the light-transmissive region 334 of the second surface 331.

In some embodiments, the light-transmissive regions 333 and 334 of the light-emitting units 111 may be a continuous region. In this case, the light-emitting unit light isolation structure 300 may be arranged in the continuous region, and may or may not be in contact with the continuous region, so that the light-emitting unit light isolation structure 300 may be arranged in the light-transmissive regions 333 and 334 of the light-emitting units 111. Optionally, the light-transmissive regions 333 and 334 of the light-emitting units 111 may be a discontinuous region. In this case, the light-emitting unit light isolation structure 300 may be arranged in the discontinuous region, and may or may not be in contact with the discontinuous region, so that the light-emitting unit light isolation structure 300 may be arranged in the light-transmissive regions 333 and 334 of the light-emitting units 111. Optionally, the position, number and the like of the discontinuous regions for allowing arrangement of the light-emitting unit light isolation structure 300 may be determined according to actual light-transmissive conditions such as process requirements, so that the light-emitting unit light isolation structure 300 may be arranged in the light-transmissive regions 333 and 334 of the light-emitting units 111 presented as the discontinuous region.

In some embodiments, the light-transmissive regions 333 and 334 of the light-emitting units 111 may be determined according to actual light-transmissive conditions such as process requirements; and accordingly, it is considered that the light-emitting unit light isolation structure 300 is arranged between the light-transmissive regions 333 and 334 of the light-emitting units 111 or the corresponding light-transmissive regions 333 and 334 of two adjacent light-emitting units 111. Optionally, the light-transmissive regions 333 and 334 may include part or all of regions of the light-emitting units 111, and may be presented in a form of continuous region or discontinuous region; and the corresponding position, quantity and the like may be determined according to actual light-transmissive conditions such as process requirements, as long as the light-emitting unit light isolation structure 300 is capable of preventing the light emitted by the two adjacent light-emitting units 111 from being transmitted in an undesired direction (e.g., the light emitted by the first light-emitting unit 320 and the second light-emitting unit 330 is transmitted to each other).

Referring to Fig. 6, in some embodiments, the light-emitting unit light isolation structure 300 may include a light-emitting unit light isolation body 301.

Referring to Fig. 7, in some embodiments, the light-emitting unit light isolation body 301 may be nonconductive and include a light isolation material 302.

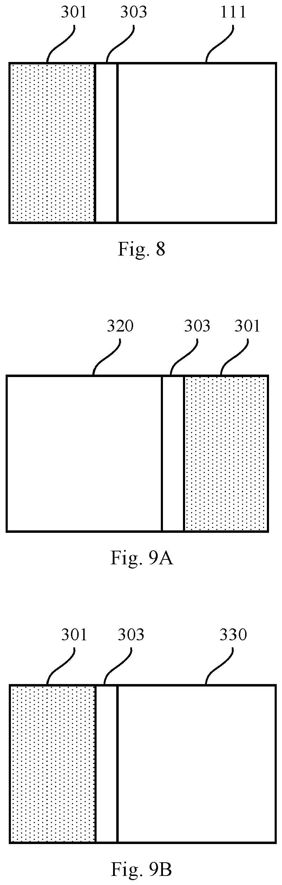

Referring to Fig. 8, in some embodiments, the light-emitting unit light isolation body 301 may be conductive. Optionally, the light-emitting unit light isolation structure 300 may further include an insulation structure 303 arranged between the light-emitting unit light isolation body 301 and a light-emitting unit 111 in need of being insulated from the light-emitting unit light isolation body 301.

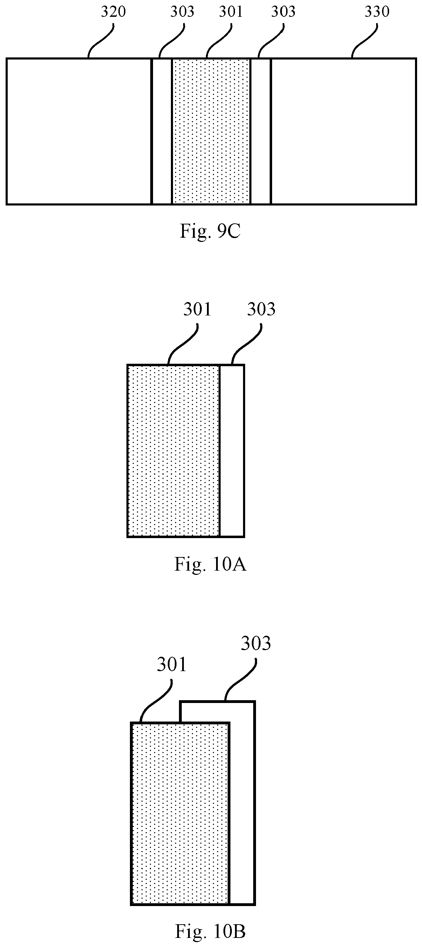

Referring to Figs. 9A, 9B and 9C, in some embodiments, the insulation structure 303 may be arranged between the light-emitting unit light isolation body 301 and at least one of the two adjacent light-emitting units 111.

In some embodiments, as shown in Fig. 9A, when the two adjacent light-emitting units 111 include the first light-emitting unit 320 and the second light-emitting unit 330, the insulation structure 303 is arranged between the light-emitting unit light isolation body 301 and the first light-emitting unit 320.

In some embodiments, as shown in Fig. 9B, when the two adjacent light-emitting units 111 include the first light-emitting unit 320 and the second light-emitting unit 330, the insulation structure 303 is arranged between the light-emitting unit light isolation body 301 and the second light-emitting unit 330.

In some embodiments, as shown in Fig. 9C, when the two adjacent light-emitting units 111 include the first light-emitting unit 320 and the second light-emitting unit 330, the insulation structure 303 is arranged between the light-emitting unit light isolation body 301 and the first light-emitting unit 320; and the insulation structure 303 is also arranged between the light-emitting unit light isolation body 301 and the second light-emitting unit 330.

In some embodiments, the arrangement position of the insulation structure 303 may be considered according to actual conditions such as process requirements, as long as the light-emitting unit light isolation body 301 may be effectively insulated from an adjacent light-emitting unit 111.

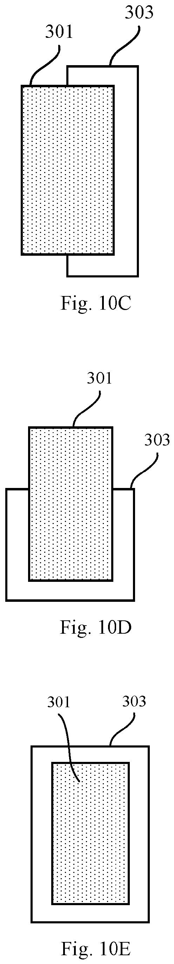

Referring to Figs. 10A, 10B, 10C, 10D and 10E, in some embodiments, the insulation structure 303 may cover a part or whole of the light-emitting unit light isolation body 301.

In some embodiments, as shown in Figs. 10A, 10B, 10C and 10D, the insulation structure 303 may cover part of the light-emitting unit light isolation body 301, such as one side, two sides, three sides or more sides of the light-emitting unit light isolation body 301.

In some embodiments, as shown in Fig. 10E, the insulation structure 303 may cover a part or whole of the light-emitting unit light isolation body 301.

In some embodiments, the arrangement mode of the insulation structure 303 (e.g., covering a part or whole of the light-emitting unit light isolation body 301) may be considered according to actual conditions such as process requirements, as long as the light-emitting unit light isolation body 301 may be effectively insulated from an adjacent light-emitting unit 111.

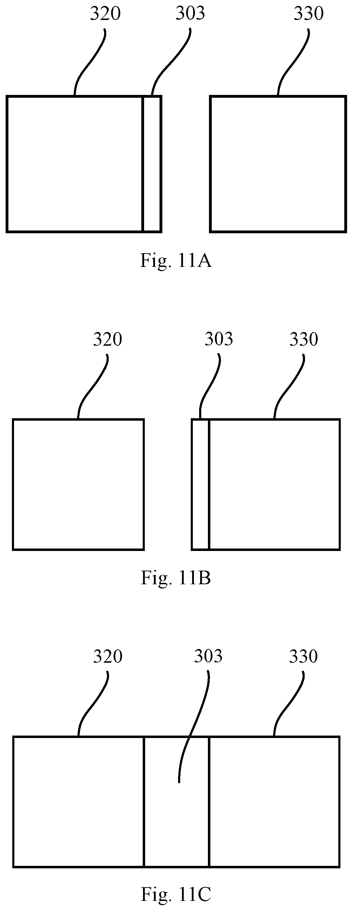

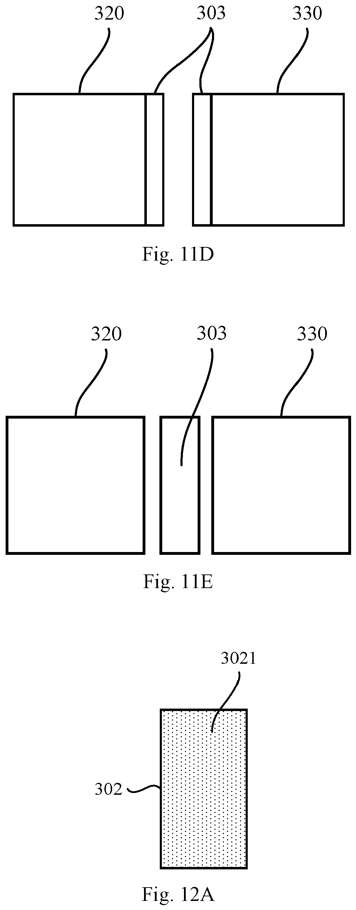

Referring to Figs. 11A, 11B, 11C, 11D and 11E, in some embodiments, the insulation structure 303 may be in contact with at least one of the two adjacent light-emitting units 111. Optionally, the insulation structure 303 may not be in contact with the two adjacent light-emitting units 111.

In some embodiments, as shown in Fig. 11A, when the two adjacent light-emitting units 111 include the first light-emitting unit 320 and the second light-emitting unit 330, the insulation structure 303 is in contact with the first light-emitting unit 320, but not in contact with the second light-emitting unit 330.

In some embodiments, as shown in Fig. 11B, when the two adjacent light-emitting units 111 include the first light-emitting unit 320 and the second light-emitting unit 330, the insulation structure 303 is in contact with the second light-emitting unit 330, but not in contact with the first light-emitting unit 320.

In some embodiments, as shown in Fig. 11C, when the two adjacent light-emitting units 111 include the first light-emitting unit 320 and the second light-emitting unit 330, the insulation structure 303 as a single whole is in contact with the first light-emitting unit 320 and the second light-emitting unit 330.

In some embodiments, as shown in Fig. 11D, when the two adjacent light-emitting units 111 include the first light-emitting unit 320 and the second light-emitting unit 330, one of two relatively independent insulation structures 303 is in contact with the first light-emitting unit 320, but not in contact with the second light-emitting unit 330, and the other insulation structure 303 is in contact with the second light-emitting unit 330, but not in contact with the first light-emitting unit 320.

In some embodiments, as shown in Fig. 11E, when the two adjacent light-emitting units 111 include the first light-emitting unit 320 and the second light-emitting unit 330, the insulation structure 303 is in contact with none of the first light-emitting unit 320 and the second light-emitting unit 330.

In some embodiments, the arrangement mode (e.g., being in contact with at least one of the two adjacent light-emitting units 111) of the insulation structure 303 may be considered according to actual conditions such as process requirements, as long as the light-emitting unit light isolation body 301 may be effectively insulated from an adjacent light-emitting unit 111.

In some embodiments, at least one of the light-emitting unit light isolation body 301 and the insulation structure 303 may include the light isolation material 302.

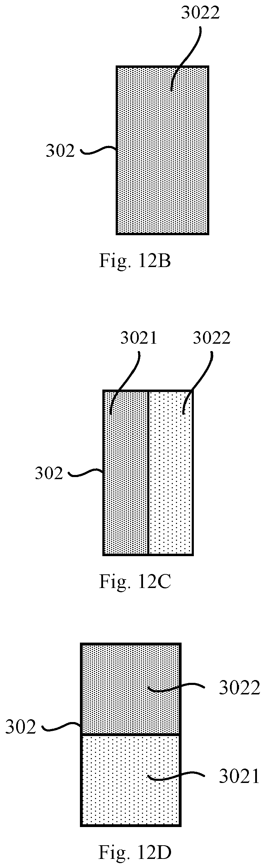

Referring to Figs. 12A, 12B, 12C and 12D, in some embodiments, the light isolation material 302 may include at least one of a light absorption material 3021 and a light reflection material 3022.

In some embodiments, as shown in Fig. 12A, the light isolation material 302 may include the light absorption material 3021.

In some embodiments, as shown in Fig. 12B, the light isolation material 302 may include the light reflection material 3022.

In some embodiments, as shown in Figs. 12C and 12D, the light isolation material 302 may include the light absorption material 3021 and the light reflection material 3022.

In some embodiments, the arrangement of the light isolation material 302 may be considered according to actual conditions such as process requirements, as long as the light isolation material 302 is capable of effectively achieving light isolation. Optionally, when the light isolation material 302 includes the light absorption material 3021 and the light reflection material 3022, the positions, proportions and the like of the light absorption material 3021 and the light reflection material 3022 may be considered according to actual conditions such as process requirements.

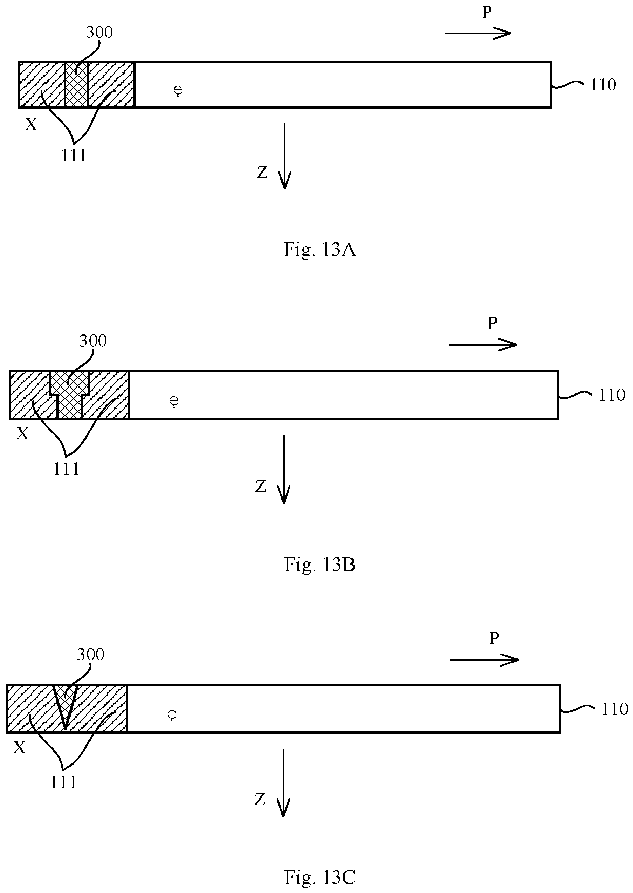

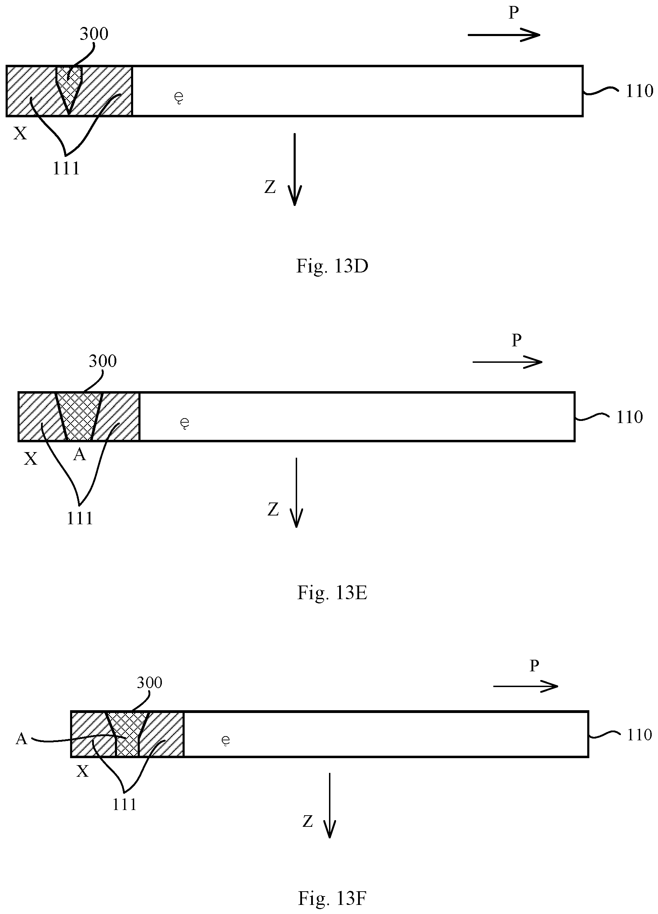

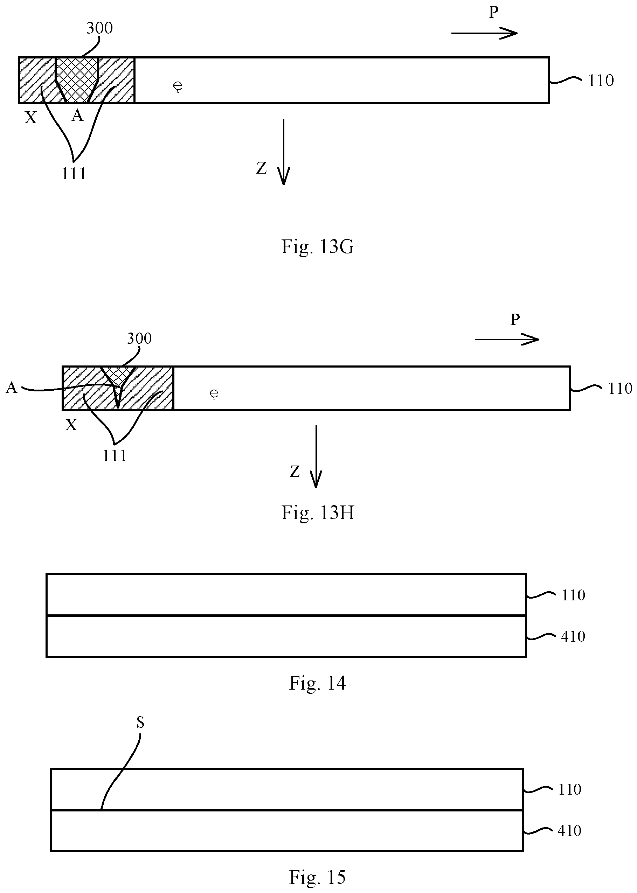

Referring to Figs. 13A, 13B, 13C, 13D, 13E, 13F, 13G and 13H, in some embodiments, part or all of cross-sectional shapes of the light-emitting unit light isolation structure 300 along a light-exiting direction Z of the light-emitting unit layer 110 include at least one of rectangular quadrangle, triangle and trapezoid.

In some embodiments, as shown in Fig. 13A, a cross-sectional shape of the light-emitting unit light isolation structure 300 along the light-exiting direction Z of the light-emitting unit layer 110 is a rectangular quadrangle.

In some embodiments, as shown in Fig. 13B, cross-sectional shapes of the light-emitting unit light isolation structure 300 along the light-exiting direction Z of the light-emitting unit layer 110 include two rectangular quadrangles; and widths of the two rectangular quadrangles in a plane direction P of the light-emitting unit layer 110 are different. Optionally, a rectangular quadrangle with a relatively small width in the plane direction P of the light-emitting unit layer 110 may be close to a light-exiting side X of the light-emitting unit layer 110; and a rectangular quadrangle with a relatively large width in the plane direction P of the light-emitting unit layer 110 may be far away from the light-exiting side X of the light-emitting unit layer 110. Optionally, a relative positional relationship between the two rectangular quadrangles may also be opposite to that shown in the figure; for example, the rectangular quadrangle with the relatively large width in the plane direction P of the light-emitting unit layer 110 may be close to the light-exiting side X of the light-emitting unit layer 110; and the rectangular quadrangle with the relatively small width in the plane direction P of the light-emitting unit layer 110 may be far away from the light-exiting side X of the light-emitting unit layer 110.

In some embodiments, as shown in Fig. 13C, a cross-sectional shape of the light-emitting unit light isolation structure 300 along the light-exiting direction Z of the light-emitting unit layer 110 is a triangle. Optionally, one side of the triangle may be far away from the light-exiting side X of the light-emitting unit layer 110. Optionally, one side of the triangle may be close to the light-exiting side X of the light-emitting unit layer 110.

In some embodiments, as shown in Fig. 13D, a cross-sectional shape of the light-emitting unit light isolation structure 300 along the light-exiting direction Z of the light-emitting unit layer 110 includes a rectangular quadrangle and a triangle. Optionally, the rectangular quadrangle may be far away from the light-exiting side X of the light-emitting unit layer 110; and the triangle may be close to the light-exiting side X of the light-emitting unit layer 110. Optionally, the relative positional relationship between the rectangular quadrangle and the triangle may be opposite to that shown in the figure, for example, the triangle may be far away from the light-exiting side X of the light-emitting unit layer 110; and the rectangular quadrangle may be close to the light-exiting side X of the light-emitting unit layer 110. Optionally, one side of the triangle may face the light-exiting side X of the light-emitting unit layer 110 or face away from the light-exiting side X of the light-emitting unit layer 110.

In some embodiments, as shown in Fig. 13E, a cross-sectional shape of the light-emitting unit light isolation structure 300 along the light-exiting direction Z of the light-emitting unit layer 110 is a trapezoid. Optionally, an upper base A of the trapezoid may face the light-exiting side X of the light-emitting unit layer 110. Optionally, the upper base A of the trapezoid may face away from the light-exiting side X of the light-emitting unit layer 110.

In some embodiments, as shown in Fig. 13F, cross-sectional shapes of the light-emitting unit light isolation structure 300 along the light-exiting direction Z of the light-emitting unit layer 110 include a trapezoid and a rectangular quadrangle. Optionally, the rectangular quadrangle may be close to the light-exiting side X of the light-emitting unit layer 110; and the trapezoid may be far away from the light-exiting side X of the light-emitting unit layer 110. Optionally, the upper base A of the trapezoid may face the light-exiting side X of the light-emitting unit layer 110 or face away from the light-exiting side X of the light-emitting unit layer 110.

In some embodiments, as shown in Fig. 13G, cross-sectional shapes of the light-emitting unit light isolation structure 300 along the light-exiting direction Z of the light-emitting unit layer 110 include a trapezoid and a rectangular quadrangle. Optionally, the rectangular quadrangle may be far away from the light-exiting side X of the light-emitting unit layer 110; and the trapezoid may be close to the light-exiting side X of the light-emitting unit layer 110. Optionally, the upper base A of the trapezoid may face the light-exiting side X of the light-emitting unit layer 110 or face away from the light-exiting side X of the light-emitting unit layer 110.

In some embodiments, as shown in Fig. 13H, cross-sectional shapes of the light-emitting unit light isolation structure 300 along the light-exiting direction Z of the light-emitting unit layer 110 includes a trapezoid and a triangle. Optionally, the trapezoid may be far away from the light-exiting side X of the light-emitting unit layer 110; and the triangle may be close to the light-exiting side X of the light-emitting unit layer 110. Optionally, the relative positional relationship between the trapezoid and the triangle may also be opposite to that shown in the figure, for example, the trapezoid may be close to the light-exiting side X of the light-emitting unit layer 110; and the triangle may be far away from the light-exiting side X of the light-emitting unit layer 110. Optionally, the upper base A of the trapezoid may face the light-exiting side X of the light-emitting unit layer 110 or face away from the light-exiting side X of the light-emitting unit layer 110. Optionally, one side of the triangle may face the light-exiting side X of the light-emitting unit layer 110 or face away from the light-exiting side X of the light-emitting unit layer 110.

In some embodiments, the cross-sectional shape of the light-emitting unit light isolation structure 300 along the light-exiting direction Z of the light-emitting unit layer 110 may be considered according to actual conditions such as process requirements, as long as the light-emitting unit light isolation structure 300 is capable of preventing the light emitted by the two adjacent light-emitting units 111 from being transmitted in an undesired direction (e.g., the light emitted by the two adjacent light-emitting units 111 is transmitted to each other).

In some embodiments, the light-emitting unit light isolation structure 300 may include a structure and material capable of realizing light isolation, such as at least one of silver, aluminum and other metals. Optionally, the structure and material of the light-emitting unit light isolation structure 300 may be determined according to actual conditions such as process requirements, as long as the light-emitting unit light isolation structure 300 is capable of preventing the light emitted by the two adjacent light-emitting units 111 from being transmitted in an undesired direction (e.g., the light emitted by the two adjacent light-emitting units 111 is transmitted to each other).

In some embodiments, the light isolation structure 300 of the light-emitting unit may also include other structures and materials capable of realizing light absorption and light reflection, such as resin composition and titanium oxide (e.g., TiO₂). Optionally, the material for realizing light absorption may also include a Black Matrix (BM). Optionally, the structure and material of the light-emitting unit light isolation structure 300 may be determined according to actual conditions such as process requirements, as long as the light-emitting unit light isolation structure 300 is capable of preventing the light emitted by the two adjacent light-emitting units 111 from being transmitted in an undesired direction (e.g., the light emitted by the two adjacent light-emitting units 111 is transmitted to each other).

Referring to Fig. 14, in some embodiments, the light-emitting module may further include a light conversion layer 410 arranged at the light-emitting unit layer 110. Optionally, the light conversion layer 410 may realize color conversion of light in a way of wavelength selection, for example, performing color conversion on light from the light-emitting unit layer 110.

Referring to Fig. 15, in some embodiments, the light conversion layer 410 may be arranged at a light-exiting surface S of the light-emitting unit layer 110.

In some embodiments, part or all of the plurality of light-emitting units 111 may be unpackaged structures.

In some embodiments, part of the plurality of light-emitting units 111 may be unpackaged structures. Optionally, one, two, three or more of the plurality of light-emitting units 111 may only be light-emitting units, which have been arranged and are capable of emitting light, but have not been packaged and have no packaging layer and other packaging structures for packaging the light-emitting units; for example, at least one of the plurality of light-emitting units 111 may be a light-emitting unit, which is formed on the basis of epitaxial growth and other ways and includes a first semiconductor layer, an active layer, a second semiconductor layer (or, may further include an electrode), but has not been packaged and has no packaging layer and other packaging structures for packaging the light-emitting unit including the first semiconductor layer, the active layer, the second semiconductor layer (or, further including an electrode).

In some embodiments, all of the plurality of light-emitting units 111 may be unpackaged structures. Optionally, all of the plurality of light-emitting units 111 may only be light-emitting units, which have been arranged and are capable of emitting light, but have not been packaged and have no packaging layer and other packaging structures for packaging the light-emitting units; for example, all of the plurality of light-emitting units 111 may be a light-emitting unit, which is formed on the basis of epitaxial growth and other ways and includes a first semiconductor layer, an active layer, a second semiconductor layer (or, may further include an electrode), but has not been packaged and has no packaging layer and other packaging structures for packaging the light-emitting unit including the first semiconductor layer, the active layer, the second semiconductor layer (or, further including the electrode).

In some embodiments, part or all of the plurality of light-emitting units 111 may be packaged structures. Optionally, one, two, three or more of the plurality of light-emitting units 111 may not only be light-emitting units, which have been arranged and are capable of emitting light, and may also be packaged to form a packaging layer and other packaging structures for packaging the light-emitting units; for example, at least one of the plurality of light-emitting units 111 may be a light-emitting unit, which is formed on the basis of epitaxial growth and other ways and includes a first semiconductor layer, an active layer, a second semiconductor layer (or, may further include an electrode), but has not been packaged and has no packaging layer and other packaging structures for packaging the light-emitting unit including the first semiconductor layer, the active layer, the second semiconductor layer (or, further including the electrode).

When part or all of the plurality of light-emitting units 111 are packaged structures, a packaged structure in which one or more light-emitting units 111 are packaged may be integrally regarded as one light-emitting unit 111; for example, if one packaged structure includes one light-emitting unit 111, the packaged structure including the one light-emitting unit 111 may be regarded as one light-emitting unit 111; and for another example, if one packaged structure includes three light-emitting units 111, the packaged structure including the three light-emitting units 111 may be regarded as one light-emitting unit 111.

In some embodiments, part or all of the plurality of light-emitting units 111 may be set to be unpackaged structures according to actual conditions such as process requirements, or part or all of the plurality of light-emitting units 111 may be set to be packaged structures according to actual conditions such as process requirements, as long as the light-emitting unit light isolation structure 300 is capable of preventing the light emitted by two adjacent light-emitting units 111 from being transmitted in an undesired direction (e.g., the light emitted by the two adjacent light-emitting units 111 is transmitted to each other).

In some embodiments, the plurality of light-emitting units 111 may include at least one of LED, Mini LED and Micro LED. Optionally, the plurality of light-emitting units 111 may include at least one LED. Optionally, the plurality of light-emitting units 111 may include at least one Mini LED. Optionally, the plurality of light-emitting units 111 may include at least one Mini LED. Optionally, the plurality of light-emitting units 111 may include at least one LED and at least one Mini LED. Optionally, the plurality of light-emitting units 111 may include at least one LED and at least one Micro LED. Optionally, the plurality of light-emitting units 111 may include at least one Mini LED and at least one Micro LED. Optionally, the plurality of light-emitting units 111 may include at least one LED, at least one Mini LED and at least one Micro LED. Optionally, the plurality of light-emitting units 111 may include other light-emitting devices besides LED, Mini LED and Micro LED.

In some embodiments, types of devices of the light-emitting unit 111, such as LED, Mini LED, Micro LED or other light-emitting devices, may be determined according to actual conditions such as process requirements.

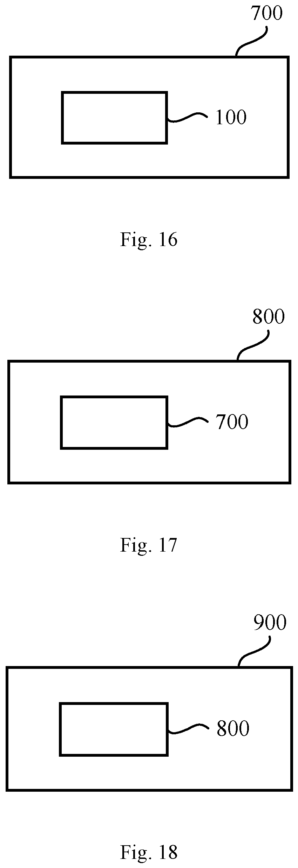

Referring to Fig. 16, a display module 700 provided by embodiments of the present disclosure includes the light-emitting module 100. In some embodiments, the display module 700 may support 3D display.

Referring to Fig. 17, a display screen 800 provided by embodiments of the present disclosure includes the display module 700. In some embodiments, the display screen 800 may perform 3D display.

Referring to Fig. 18, a display 900 provided by embodiments of the present disclosure includes the display screen 800. In some embodiments, the display 900 may perform 3D display. In some embodiments, the display 900 may further include other components for supporting normal operation of the display 900, such as at least one of a communication interface, a framework, a control circuit and the like.

According to the light-emitting module, the display module, the display screen and the display provided by embodiments of the present disclosure, light emitted by the light-emitting units is prevented from being transmitted in an undesired direction as far as possible by arranging the light-emitting unit light isolation structure between two adjacent light-emitting units in part or all of the plurality of light-emitting units, thereby benefiting improvement of display effect and having a possibility of improving a light utilization rate.

The above description and drawings sufficiently illustrate the embodiments of the present disclosure to enable those skilled in the art to practice them. Other embodiments may comprise structural, logical, electrical, process, and other changes. The embodiments represent only possible changes. Unless expressly required, individual components and functions are optional and the order of operations may be changed. Parts and features of some embodiments may be included in or substituted for parts and features of other embodiments. The scope of the disclosed embodiments includes the full scope of the claims, and all available equivalents of the claims. When used in the present application, although the terms of "first", "second", etc. may be possibly used in the present application to describe various elements, these elements should not be limited by these terms. These terms are only used to distinguish one element from another. For example, without changing the meaning of the description, a first element may be called as a second element, and similarly, the second element may be called as the first element, as long as all of "the first elements" that appear are consistently renamed and all of "the second elements" that appear are consistently renamed. The first element and the second element are both elements, but may not be the same element. Moreover, the terms used in the present application are used to describe the embodiments only and not to limit the claims. As used in the illustration of the embodiments and the claims, unless clearly indicated in the context, the singular forms "a", "an" and "the" are also intended to include the plural forms. Similarly, the term "and/or" as used in the present application is meant to include any and all possible combinations of one or more of the associated listings. In addition, when used in the present application, the term "comprise" and its variations "comprises" and/or "comprising", etc., refer to the presence of stated features, integers, steps, operations, elements, and/or components, but does not preclude the presence or addition of one or more other features, integers, steps, operations, elements, components and/or groupings of these. Without further limitations, an element limited by the phrase "comprises a..." does not preclude the presence of additional identical elements in the process, method or device that includes the element. Herein, the difference of each embodiment from each other may be the focus of explanation. The same and similar parts among all of the embodiments may be referred to each other. For the method and product disclosed by the embodiments, if the method and product correspond to a method part disclosed by the embodiments, the description of the method part can be referred to for the related part.

Those skilled in the art may recognize that the units and algorithm steps of each example described in conjunction with the embodiments disclosed herein can be implemented in electronic hardware, or a combination of computer software and electronic hardware. Whether these functions are performed in hardware or software may depend on the specific application and design constraints of the technical solution. Those skilled in the art may use different methods for implementing the described functions for each particular application, but such implementations should not be considered beyond the scope of the embodiments of the present disclosure. Those skilled in the art may clearly understand that, for the convenience and brevity of description, the corresponding processes in the above method embodiments may be referred to for the working processes of the above systems, devices and units, which will not be repeated here.

In the embodiments disclosed herein, the disclosed method and product (including, but not limited to the apparatus and the device) may be realized in other ways. For example, the device embodiments described above are merely schematic. For example, the division of the units may be only a logical functional division, and may be an additional division manner in actual realization. For example, multiple units or components may be combined or integrated into another system, or some features may be ignored or not executed. In addition, the displayed or discussed mutual coupling or direct coupling or communication connection may be indirect coupling or communication connection through some interfaces, devices or units, and may be electrical, mechanical or other forms. The units described as separate components may or may not be physically separated, and the components shown as the units may or may not be physical units, that is, may be located in one place, or may be distributed on multiple network units. The present embodiments may be implemented by selecting some or all of the units according to actual needs. In addition, each functional unit in the embodiments of the present disclosure may be integrated into one processing unit, or each unit may exist physically alone, or two or more units may be integrated into one unit.

In the accompanying drawings, width, length, thickness and the like of structures such as elements or layers may be exaggerated for clarity and description. When a structure such as an element or layer is referred to as being "arranged" (or "mounted", "laid", "attached", "coated" and the like) "above" or "on" another element or layer, the structure such as the element or layer may be directly "arranged" "above" or "on" another element or layer, or a structure such as an intermediate element or layer exists between the element or layer and the another element or layer and even is partially embedded in the another element or layer.

## Claims

1. A light-emitting module, comprising:
a light-emitting unit layer, comprising a plurality of light-emitting units;
wherein a light-emitting unit light isolation structure is arranged between two adjacent light-emitting units in part or all of the plurality of light-emitting units.

2. The light-emitting module according to claim 1, wherein the light-emitting unit light isolation structure is arranged in a partial or whole region between the two adjacent light-emitting units.

3. The light-emitting module according to claim 2, wherein there is a light-emitting unit spacing region between the two adjacent light-emitting units, and the light-emitting unit light isolation structure is arranged in a part or whole of the light-emitting unit spacing region.

4. The light-emitting module according to claim 3, wherein the two adjacent light-emitting units comprise a first light-emitting unit and a second light-emitting unit; the first light-emitting unit comprises a first surface close to the second light-emitting unit; and the second light-emitting unit comprise a second surface close to the first light-emitting unit;
wherein the light-emitting unit light isolation structure is arranged on at least one of the first surface and the second surface, or is not in contact with the first surface or the second surface.

5. The light-emitting module according to claim 4, wherein the light-emitting unit light isolation structure is arranged in a light-transmissive region of at least one of the first surface and the second surface.

6. The light-emitting module according to any one of claims 1-5, wherein the light-emitting unit light isolation structure comprises a light-emitting unit light isolation body.

7. The light-emitting module according to claim 6, wherein the light-emitting unit light isolation body is nonconductive and comprises a light isolation material.

8. The light-emitting module according to claim 6, wherein the light-emitting unit light isolation body is conductive;
the light-emitting unit light isolation structure further comprises an insulation structure arranged between the light-emitting unit light isolation body and a light-emitting unit in need of being insulated from the light-emitting unit light isolation body.

9. The light-emitting module according to claim 8, wherein the insulation structure is arranged between the light-emitting unit light isolation body and at least one of the two adjacent light-emitting units.

10. The light-emitting module according to claim 9, wherein the insulation structure covers a part or whole of the light-emitting unit light isolation body.

11. The light-emitting module according to claim 8, wherein at least one of the light-emitting unit light isolation body and the insulation structure comprises a light isolation material.

12. The light-emitting module according to claim 8, wherein
the insulation structure is in contact with at least one of the two adjacent light-emitting units; or
the insulation structure is not in contact with the two adjacent light-emitting units.

13. The light-emitting module according to claim 7 or 11, wherein the light isolation material comprises at least one of a light absorption material and a light reflection material.

14. The light-emitting module according to claim 1, wherein part or all of shapes in cross-sectional shapes of the light-emitting unit light isolation structure along a light-exiting direction of the light-emitting unit layer comprise at least one of a rectangular quadrangle, a triangle and a trapezoid.

15. The light-emitting module according to claim 14, wherein cross-sectional shapes of the light-emitting unit light isolation structure along a light-exiting direction of the light-emitting unit layer comprise a trapezoid, and an upper base of the trapezoid faces a light-exiting side of the light-emitting unit layer.

16. The light-emitting module according to any one of claims 1-15, further comprising: a light conversion layer arranged at the light-emitting unit layer.

17. The light-emitting module according to claim 16, wherein the light conversion layer is arranged at a light-exiting surface of the light-emitting unit layer.

18. The light-emitting module according to claim 1, wherein part or all of the plurality of light-emitting units are unpackaged structures.

19. The light-emitting module according to claim 1, wherein the plurality of light-emitting units comprise:
at least one of a light-emitting diode (LED), a Mini LED and a Micro LED.

20. A display module, comprising the light-emitting module of any one of claims 1-19.

21. A display screen, comprising the display module of claim 20.

22. A display, comprising the display screen of claim 21.
